# EUROPEAN PATENT APPLICATION

(11) **EP 4 800 382 A1**
(43) Date of publication of application: **02.09.2026**
(21) Application number: 25160340.3
(22) Date of filing: 26.02.2025
(51) Int. Cl.: G01N 24/10, G01N 21/62, G01N 24/00, G01R 33/032

(54) **METHODS AND SYSTEMS FOR DETERMINING BIOCOMPATIBILITY OF MATERIALS**

(71) Applicant: RIJKSUNIVERSITEIT GRONINGEN, 9712 CP Groningen (NL); Academisch Ziekenhuis Groningen, 9713 GZ Groningen (NL)
(72) Inventor: SCHIRHAGL, Romana, 9713 AV Groningen (NL); MZYK, Aldona, 9713 AV Groningen (NL); WOJTAS, Daniel, 9713 AV Groningen (NL)
(74) Representative: V.O.

(57) **Abstract**

A method and system for determining biocompatibility ("BC") of a biological sample ("S") with a solid test material ("M"). A testing apparatus (100) comprises a material region (10R) containing the solid test material ("M"); and a sample region (20R) containing the biological sample ("S") comprising biological cells ("Sc") into which nanocrystals ("NC") with color centers ("CC") have been introduced. A liquid medium ("L") fluidly connects the material region (10R) with the sample region (20R) and carries dissolvable components ("Mc") from the solid test material ("M") into contact with the biological cells ("Sc"). Optical measurements are performed on the biological sample ("S") to determine a time-dependent spin state of the color centers ("CC") of the respective nanocrystals ("NC") as local indicators of a biological response ("Br") of the biological cells ("Sc") to the dissolvable components ("Mc"). The biocompatibility ("BC") is determined based on the optical measurements.

## Description

### TECHNICAL FIELD AND BACKGROUND

The present disclosure relates to methods and systems for determining biocompatibility of materials, in particular materials intended for medical applications such as implants.

With the growing number of implanted medical devices and increasing personal healthcare digitization, advanced risk assessment of materials has become of utmost importance. Materials intended for implants, medical devices, and drug carriers must be biocompatible and should not promote adverse effects such as cytotoxicity, uncontrolled inflammation, or foreign body responses. Beyond being non-immunogenic and non-cytotoxic, materials used for implantation should also be nongenotoxic to prevent potential mutations that could lead to tumor formation.

Currently, biocompatibility testing typically relies on static conditions where cells are either exposed to an extract from a test material or placed in direct contact with the material. However, these static testing conditions do not accurately represent many real-world applications. For example, when testing a stent material, the cells may not necessarily be in direct contact with the material, and there is typically a constant flow of blood present in the actual physiological environment. Additionally, direct contact testing can introduce mechanical stress effects that interfere with measuring the true chemical or biological interactions between the material and cells.

Moreover, conventional biocompatibility assays cannot effectively detect early-stage molecular markers that could enable identification of initial cellular responses before visible signs of damage or stress appear. The ability to continuously monitor cellular status under flow conditions that better simulate physiological environments remains a significant challenge in the field. Current methods are particularly limited in their ability to detect subtle changes in cellular metabolism and stress responses that may indicate potential compatibility issues.

There remains a need for improved methods and systems that can monitor material-biological interactions under conditions that better represent the actual environment these materials will encounter in medical applications. Such methods should ideally provide real-time, continuous monitoring capabilities while avoiding the limitations of static testing conditions and enabling detection of early-stage cellular responses that could predict potential biocompatibility issues.

### SUMMARY

Aspects of the present disclosure relate to methods and systems for determining biocompatibility of biological samples with test material, in particular solid test material such as used for medical implants. A testing apparatus comprises a material region containing the test material and a sample region containing the biological sample. The biological sample comprises biological cells into which nanocrystals with color centers have been introduced. A liquid medium is provided to fluidly connect the material region with the sample region. The liquid medium is configured to carry dissolvable components from the test material. The dissolvable components may be brought into contact with the biological cells of the biological sample via the liquid medium. Optical measurements are performed on the biological sample to determine a time-dependent spin state of the color centers of the respective nanocrystals. These may serve as local indicators of a biological response of the biological cells to the dissolvable components. The biocompatibility of the biological sample with the test material can thus be determined based on the optical measurements.

Nanocrystals with color centers, when incorporated as cellular sensors, may provide insight into early-stage cellular responses across a range of medical implant applications including cardiovascular devices, orthopedic implants, dental prosthetics, drug-eluting devices, and biodegradable scaffolds. Through quantum sensing capabilities, subtle changes in the cellular environment caused by material interactions may become detectable, including variations in free radical production, metabolic activity, and stress responses - all before conventional assays may show visible effects. Optical measurements of color center quantum states may enable continuous, non-invasive monitoring of dynamic cellular responses as materials may degrade, release components, or undergo surface changes. Without being bound by theory, cellular responses to test materials may create distinct magnetic environments that may influence color center spin states, yielding measurable optical signals. For example, in drug-eluting cardiovascular stents or orthopedic implants, the approach may enable monitoring of cellular responses to controlled therapeutic agent release under physiological flow conditions. Similarly, for biodegradable dental or tissue scaffolds, material degradation progression and resulting cellular effects may become trackable in real-time. This quantum sensing approach may thus yield molecular-level information about material-cell interactions that may be critical for biocompatible material development and validation across the full spectrum of medical implant applications.

By fluidly connecting test materials and biological samples via a liquid medium, the biocompatibility testing may enable measurement of material-cell interactions without mechanical contact effects that could mask or interfere with true chemical and biological responses, while controlled fluid connections may expose cells to material components at distances that better represent real physiological situations where direct contact may not occur. This arrangement may be particularly valuable for applications where material influence extends beyond direct contact, such as testing stents, drug-eluting implants, or biodegradable materials that may release active components over time. The fluid connection may further enable simulation of physiological conditions through controlled handling that replicates relevant biological environment aspects including flow conditions, temperature, pH, and biochemical composition. In cardiovascular applications, for instance, the liquid medium may comprise simulated blood plasma containing appropriate proteins and cells while maintaining pulsating flow characteristics that match those found in blood vessels. For example, the pressure and/or velocity of the pulsating flow may vary by at least 10%, at least 20%, at least 50%, or more, e.g. with at least a factor two. By way of illustration, arterial pressure commonly varies from around 80 mmHg (diastolic) to 120 mmHg (systolic) - a difference of roughly 50% - and peak systolic velocity may typically exceed diastolic velocity by a factor of two or more.

While the material and sample regions may be arranged in a shared space, maintaining fluid connection in a simple configuration, separate compartments connected by channels may provide several additional advantages. For example, the spatial separation may allow precise control over exposure conditions, may prevent unintended direct contact between materials and cells, and may enable independent optimization of conditions in each compartment. Multiple channels between compartments may provide control over flow distribution and exposure patterns. Additionally, separate compartments may allow different environmental conditions to be maintained in the material and sample regions. For example, the material compartment may be optimized for controlled material degradation or drug release, while the sample compartment may be maintained under ideal cellular growth conditions. This separation may also facilitate independent access to either region for sampling or measurements without disturbing the other region. In either arrangement, flow conditions may be adjusted between continuous flow, pulsating flow simulating physiological conditions, or static conditions depending on specific testing requirements. The inclusion of return flow channels may enable medium recirculation, which may provide several additional benefits. Recirculation may facilitate long-term testing while conserving valuable test materials and biological samples. It may also allow accumulation of released components to physiologically relevant concentrations and may enable studying extended exposure effects. Such adaptability in flow configuration may permit optimization for diverse material types and applications.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 illustrates a schematic representation of a testing apparatus for determining biocompatibility of a biological sample with a test material;
FIG 2A illustrates an energy level diagram for a color center;
FIG 2B illustrates an example of average electron-spin state occupancy during different measurement steps.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise, it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or crosssection illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

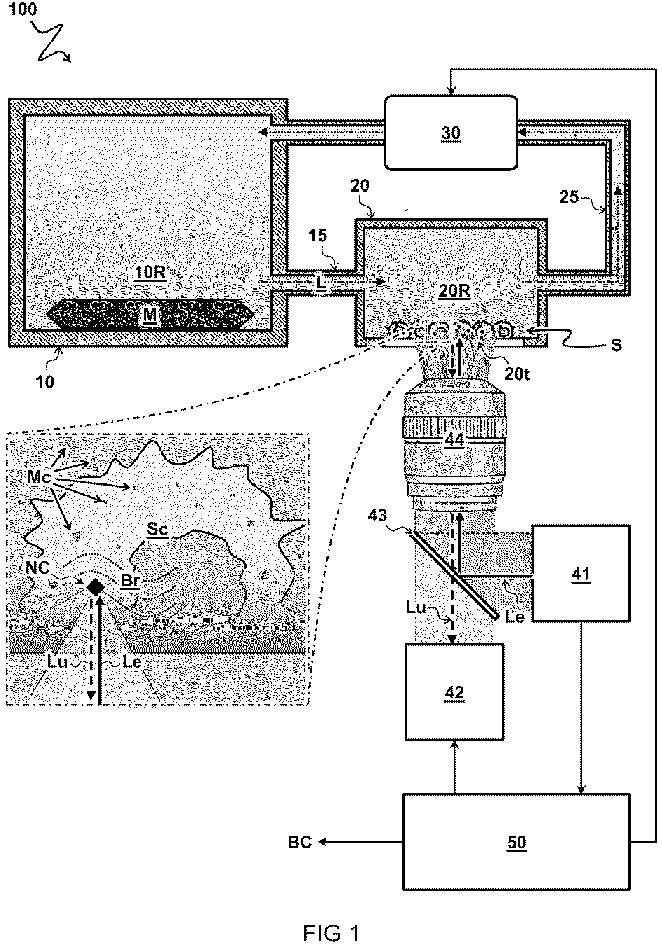

FIG 1 illustrates a testing apparatus 100 for determining biocompatibility "BC" of a biological sample "S" with a test material "M". The testing apparatus 100 comprises material region 10R for containing the test material "M" and a sample region 20R for containing the biological sample "S". The biological sample "S" may comprise one or more biological cells "Sc". As shown in the figure inset, a nanocrystal "NC" with color centers "CC" has been introduced into a respective biological cell "Sc". A liquid medium "L" is provided to fluidly connect the material region 10R with the sample region 20R. The liquid medium "L" is configured to carry any dissolvable components "Mc" from the test material "M" and bring the dissolvable components "Mc", via the liquid medium "L", into contact with the biological cells "Sc" of the biological sample "S". Optical measurements are performed on the biological sample "S" to determine a time-dependent spin state of the color centers "CC" of a respective nanocrystal "NC" as local indicator of a biological response "Br" of the respective biological cell "Sc" to the dissolvable components "Mc". The biocompatibility "BC" of the biological sample "S" with the test material "M" may thus be determined based on the optical measurements.

In some embodiments, the material region 10R is formed within a material compartment 10 configured to hold the test material "M", which is preferably in solid form, in contact with a liquid medium "L". In other or further embodiments, the sample region 20R is formed within a sample compartment 20 configured to hold the biological sample "S". Preferably, the material compartment 10 and sample compartment 20 are fluidly connected via a channel 15. The channel 15 may enable the liquid medium "L" to carry dissolvable components "Mc" from the solid test material "M" to the biological cells "Sc". In other or further embodiments, the material compartment 10 and sample compartment 20 may be modular components that can be readily exchanged or modified. This modularity may enable testing of different material formats, cell types, and experimental configurations while maintaining consistent measurement conditions. The modular design may also facilitate cleaning and preparation between experiments.

In some embodiments, the testing apparatus 100 comprises a flow control system 30 configured to control movement of the liquid medium "L" between the material compartment 10 and sample compartment 20. The flow control system 30 may comprise one or more pumps, valves, or other flow control elements for regulating flow rate, pressure, and flow patterns of the liquid medium "L". As will be appreciated, controlled flow conditions may enable simulation of physiologically relevant environments and/or simply used to controllably transport the dissolvable components "Mc" from the material compartment 10 to the sample compartment 20. In preferred embodiments, the testing apparatus 100 further comprises a return flow channel 25 connecting an outlet of the sample compartment 20 back to an inlet of the material compartment 10. The return flow channel 25 may enable closed-loop circulation of the liquid medium "L". As will be appreciated, circulation may be particularly advantageous for long-term testing while conserving the liquid medium "L" and allowing accumulation of dissolvable components "Mc" to physiologically relevant concentrations.

The testing apparatus 100 preferably comprises an optical measurement system for performing the optical measurements. In one embodiment, the optical measurement system comprises a light source 41 configured to generate excitation light "Le" for illuminating the biological sample "S". For example, the light source 41 may comprise one or more lasers, LEDs, or other light sources selected for excitation of the color centers "CC". The excitation wavelength is preferably chosen to minimize cellular autofluorescence while maintaining effective color center excitation. In another or further embodiment, the optical measurement system comprises a light detector 42 configured to measure luminescent light "Lu" emitted from the biological sample "S" in response to the excitation light "Le". Typically, the luminescent light "Lu" is at a different wavelength than the excitation light "Le", e.g. red-shifted. Preferably, the light source 41 and detector 42 are arranged to perform measurements through a sample surface 20t of the sample compartment 20 transparent to the excitation light "Le" and luminescent light "Lu". Most preferably, the biological sample "S" is attached to the transparent sample surface 20t

Typically, the optical measurement system comprises optical elements for directing the excitation light "Le" to the biological sample "S" and/or collecting the luminescent light "Lu" from the biological sample "S". The optical elements may include, for example, mirrors, lenses, filters, beam splitters, and/or other optical components arranged to optimize excitation and detection efficiency. In one embodiment, the optical elements comprise an objective lens 44 positioned adjacent to the transparent surface 20t for focusing the excitation light "Le" onto the biological sample "S" and/or collecting the luminescent light "Lu". In another or further embodiment, the optical elements comprise an optical filter and/or (dichroic) beam splitter to separate the luminescent light "Lu" from the excitation light "Le". Of course also other or further optical elements may be envisaged and in other arrangements than shown. For example, the excitation light "Le" may be directed from one side of the biological sample "S" and the luminescent light "Lu" may be collected from the other side.

Preferably, the light source 41 is configured to provide controlled pulses of excitation light "Le". For example, these may be used for time-resolved measurements. In time-resolved measurements, the light detector 42 may be configured to resolve both temporal characteristics of the luminescent light "Lu". For example, the detector may employ time-gated detection to measure luminescence decay profiles. Alternatively, the optical measurements may employ continuous wave excitation. In this case, the light source 41 may provide constant illumination while the light detector 42 monitors steady-state luminescence intensity. In some embodiments, the light detector 42 may also be configured to resolve spectral characteristics of the luminescent light "Lu". For example, the detector may comprise wavelength-selective elements such as filters or a spectrometer to analyze the spectral distribution of emitted light. This spectral resolution capability may enable discrimination between luminescence from different types of color centers "CC" or between color center emission and cellular autofluorescence. Most preferably, the detection system may perform simultaneous temporal and spectral analysis of the luminescent light "Lu", providing complementary information about the state of the color centers "CC" and their local cellular environment.

In preferred embodiments, the optical measurement system comprises focusing and collection optics. The objective lens 44 may be selected to provide efficient excitation of color centers and collection of luminescence, with capabilities for both high-resolution single-cell measurements and wide-field imaging of cell populations. In some embodiments, confocal capabilities enable detailed measurements focused on individual biological cells "Sc", providing insights into local cellular responses while minimizing interference from surrounding cells. In other or further embodiments, wide-field imaging enables simultaneous monitoring of multiple cells across the sample region 20R, facilitating statistical analysis of population-level responses. Most preferably, the optical system can switch between these modes, combining detailed single-cell studies with broader population analysis. The system may also enable spatial mapping through either scanning excitation and detection across individual cells or capturing simultaneous responses from multiple cells, thereby revealing spatial variations in material-cell interactions.

In some embodiments, the testing apparatus 100 comprises a control unit 50. In one embodiment, the control unit 50 is configured to control the optical measurement system, e.g. to perform time-dependent measurements of a spin state of the color centers "CC" In another or further embodiment, the control unit 50 is configured to determine the biocompatibility ("BC") based on the time-dependent measurements. The control unit 50 may be operatively connected to the light source 41 and/or light detector 42. For example, the control unit 50 may control timing of excitation pulses, collection of luminescence data, and analysis of time-dependent spin state measurements. Also, a position of the light on the sample may be controlled by the control unite 50. The same or other control unit may also be operatively connected to the flow control system 30, e.g. configured to coordinate flow conditions. Alternatively, the flow conditions may be fixed.

The testing apparatus 100 may be configured to maintain relevant environmental conditions. In some embodiments, the testing apparatus 100 comprises temperature control elements for maintaining physiological temperatures in the material compartment 10 and sample compartment 20. The testing apparatus 100 may further comprise sensors for monitoring parameters such as temperature, pH, oxygen levels, and other relevant conditions.

The material region 10R may be configured in various ways to accommodate different types and formats of test materials while ensuring controlled exposure to the liquid medium "L". In some embodiments, the material region 10R is configured to hold the solid test material "M" fully submerged in the liquid medium "L". Alternatively, or in addition, the material region 10R may be configured to expose only selected surfaces of the solid test material "M" to the liquid medium "L". In preferred embodiments, the material compartment 10 comprises mounting features for securing the solid test material "M" in a defined position and orientation. The mounting features may include, for example, clips, clamps, brackets, or other mechanical fasteners suitable for the particular material format being tested. In some embodiments, the mounting features are adjustable to accommodate test materials of different sizes and shapes while maintaining consistent flow conditions around the material.

In some embodiments, the material compartment 10 is configured to create specific flow patterns around the solid test material "M". In one embodiment, the material compartment 10 comprises flow guide structures for directing the liquid medium "L" across particular surfaces or regions of the test material. The flow guide structures may include baffles, channels, or other features that create desired flow characteristics. In another or further embodiment, the material compartment 10 comprises multiple inlet and/or outlet ports positioned to generate uniform flow distribution across the test material surface.

In some embodiments, the material compartment 10 is configured to simulate specific physiological environments. For example, when testing stent materials, the material compartment 10 may comprise a tubular channel dimensioned to match relevant blood vessel geometries, with the stent material mounted within the channel. The flow conditions and channel geometry may be designed to recreate mechanical and fluid dynamic conditions experienced by stents in vivo.

The material compartment 10 may be adapted for different material formats. In one embodiment, the material compartment 10 comprises a recess or well configured to hold material samples in the form of discs, blocks, or other regular geometries. In another or further embodiment, the material compartment 10 comprises mounting points for securing material samples in the form of strips, wires, or other elongated formats. Most preferably, the material compartment 10 is configured to maintain consistent exposure conditions regardless of the material format.

In preferred embodiments, the material compartment 10 enables controlled release of dissolvable components "Mc" from the solid test material "M". The material compartment 10 may comprise features for managing the accumulation and transport of released components. In some embodiments, the material compartment 10 includes mixing features to ensure uniform distribution of released components in the liquid medium "L". In other or further embodiments, the material compartment 10 comprises sampling ports for monitoring component release over time.

The material compartment 10 may be configured for environmental control. In some embodiments, the material compartment 10 comprises temperature control elements for maintaining physiological temperatures. The material compartment 10 may further comprise sensors for monitoring parameters such as temperature, pH, and dissolved oxygen levels. In preferred embodiments, the material compartment 10 enables independent control of environmental conditions without affecting the sample compartment 20.

The sample region 20R may be configured to maintain biological cells "Sc" under controlled conditions while enabling optical access for measurements. In preferred embodiments, the sample region 20R provides a stable environment for cell culture while allowing exposure to dissolvable components "Mc" via the liquid medium "L".

In one embodiment, the sample compartment 20 comprises a cell culture surface for attaching or growing the biological cells "Sc". The cell culture surface may be formed by the transparent surface 20t to enable direct optical access to the cells. Preferably, the cell culture surface is treated or coated to promote cell adhesion and maintain cell viability. For example, the surface may be coated with extracellular matrix proteins, cell adhesion peptides, or other biocompatible materials suitable for the specific cell type being tested.

The sample compartment 20 may be configured with different geometries for cell containment. In some embodiments, the sample compartment 20 comprises a flat chamber with the cell culture surface forming one wall. In other or further embodiments, the sample compartment 20 may comprise channels or wells for organizing cells in specific patterns or densities. Most preferably, the geometry is optimized to maintain uniform exposure of cells to the liquid medium "L" while ensuring adequate optical access.

In preferred embodiments, the sample compartment 20 enables precise control over the cellular environment. The sample compartment 20 may comprise features for regulating temperature, pH, gas exchange, and other parameters critical for cell viability. In some embodiments, the sample compartment 20 includes gas-permeable membranes or surfaces to facilitate oxygen and carbon dioxide exchange. The sample compartment 20 may further comprise integrated sensors for monitoring environmental conditions.

The sample compartment 20 may be specially adapted for different types of biological samples "S". In one embodiment, the sample compartment 20 is configured to maintain adherent cell monolayers attached to the transparent surface 20t. In another or further embodiment, the sample compartment 20 may be configured to contain suspended cells, tissue sections, or three-dimensional cell cultures. Most preferably, the sample compartment 20 can accommodate various sample formats while maintaining consistent measurement conditions.

In some embodiments, the sample compartment 20 is designed to create specific flow conditions over the biological cells "Sc". The sample compartment 20 may comprise flow distribution features to ensure uniform exposure of cells to the liquid medium "L". For example, the sample compartment 20 may include microfluidic channels, barriers, or other structures that control local flow patterns. In preferred embodiments, the flow conditions can be adjusted to simulate different physiological environments.

The sample compartment 20 preferably provides optimal conditions for optical measurements. In one embodiment, the transparent surface 20t comprises high-quality optical material with minimal autofluorescence and aberrations. The transparent surface 20t may be optimized for the specific wavelengths used for excitation and detection. In another or further embodiment, the sample compartment 20 may comprise anti-reflection coatings or other optical treatments to enhance measurement sensitivity.

Most preferably, the sample compartment 20 enables long-term observation of cellular responses. The sample compartment 20 may comprise features for maintaining sterility during extended experiments. In some embodiments, the sample compartment 20 includes ports or access points for medium exchange, sampling, or addition of compounds. The sample compartment 20 may further comprise markers or reference points for tracking specific cells or regions over time.

In preferred embodiments, the sample compartment 20 is designed for experimental reproducibility and ease of use. The sample compartment 20 may comprise registration features for consistent positioning relative to the optical measurement system. The sample compartment 20 may be constructed from materials compatible with standard sterilization methods.

The sample compartment 20 may also be configured for parallel testing of multiple conditions. In some embodiments, the sample compartment 20 comprises multiple chambers or regions that can be independently exposed to different conditions. The sample compartment 20 may include features for isolating these regions while maintaining shared environmental control. This configuration may enable simultaneous comparison of different test conditions or materials while minimizing experimental variables.

The testing apparatus 100 may comprise various flow control features for regulating movement of the liquid medium "L" between the material region 10R and sample region 20R. In one embodiment, the flow control system 30 comprises a pump configured to generate controlled flow of the liquid medium "L". The pump may be selected from various types including peristaltic pumps, syringe pumps, or microfluidic pumps depending on the required flow characteristics. In some embodiments, the flow control system 30 is configured to generate different flow patterns. In one embodiment, the flow control system 30 is configured to provide continuous flow at constant rate. In another or further embodiment, the flow control system 30 is configured to generate pulsatile flow, e.g. to simulate cardiovascular conditions. Most preferably, the flow pattern can be programmed to match specific physiological situations. For example, when testing vascular implant materials, the flow pattern may be synchronized to typical heart rate and pressure profiles.

The testing apparatus 100 may be adapted for various specialized testing configurations. In one embodiment, the material region 10R is configured to accommodate pharmaceutical formulations such as slowly dissolving pills. The flow conditions and environmental parameters may be adjusted to simulate physiological conditions relevant to drug dissolution and absorption. In another or further embodiment, multiple material compartments may be arranged in parallel to enable simultaneous testing of different material formulations or surface treatments. For testing biodegradable implant materials, the material region 10R may be configured to simulate relevant mechanical and biochemical conditions. The liquid medium "L" may be selected to match the physiological environment at the intended implantation site, including appropriate proteins, cells, and other biological components. Most preferably, the testing conditions are optimized to predict in vivo material performance and biocompatibility "BC".

In preferred embodiments, the flow control system 30 comprises one or more sensors (not shown) for monitoring flow conditions. The sensors may measure parameters such as flow rate, pressure, temperature, and composition of the liquid medium "L". In some embodiments, the sensors provide feedback for automated adjustment of flow parameters. The flow control system 30 may further comprise pressure relief valves or other safety features to prevent excessive pressure buildup. The flow control system 30 may be configured for closed-loop circulation via the return flow channel 25. In some embodiments, the flow control system 30 comprises reservoir chambers for storing and conditioning the liquid medium "L". The reservoir chambers may include features for temperature control, gas exchange, and filtering of the circulating medium. Most preferably, the circulation system enables extended testing periods while maintaining stable medium composition.

In preferred embodiments, the flow control system 30 is configured to maintains stable environmental conditions. For example, the flow system may comprise temperature control elements for maintaining physiological temperatures throughout the flow path. In some embodiments, the flow system includes gas exchange membranes or surfaces for controlling dissolved gas levels. The flow system may further comprise pH buffering or adjustment capabilities. The flow control system 30 may also be configured for parallel testing configurations. In some embodiments, the flow system comprises multiple independent flow paths that can be controlled separately. The flow system may include features for splitting and combining flows while maintaining consistent conditions. This configuration may enable simultaneous testing of multiple conditions or materials while ensuring comparable flow environments.

In preferred embodiments, the flow control system 30 enables control over the exposure of biological cells "Sc" to dissolvable components "Mc". For example, the flow rate may be adjusted to control the concentration and residence time of released components. In some embodiments, the flow system comprises mixing chambers or elements to ensure uniform distribution of components in the liquid medium "L". The flow system may further comprise sampling ports for monitoring component concentrations over time. The dissolvable components "Mc" released from the solid test material "M" may affect cellular responses through multiple mechanisms. In one embodiment, these components trigger changes in cellular metabolism, leading to altered production of free radicals and reactive oxygen species. These species create local magnetic fields that interact with the color centers "CC", affecting their electron spin states and consequently the measured luminescence "Lu". In another or further embodiment, the components may influence concentrations of paramagnetic species within the cells, creating magnetic noise that affects relaxation times of the color centers. The testing apparatus 100 may enables correlation between temporal changes in measured luminescence "Lu" and the release kinetics of dissolvable components "Mc". This correlation provides insight into both the rate of material degradation or component release and the resulting cellular responses. As will be appreciated, this capability is particularly valuable for evaluating materials intended for controlled release applications.

In a preferred embodiment, the test material "M" comprises one or more implant materials for use as part of a medical implant. Examples of implant materials to be tested may include one or more selected from the list of metallic materials, polymeric materials, ceramic materials, and composite materials. Typical materials to be tested for use as metallic implant materials may include one or more selected from the list of (biodegradable) zinc-based alloys, (biodegradable) magnesium-based alloys, titanium alloys, stainless steel alloys, cobalt-chromium alloys, and nickeltitanium alloys. Typical materials to be tested for use as polymeric implant materials may include one or more selected from the list of biodegradable polymers, polyether ether ketone, ultra-high-molecular-weight polyethylene, polymethyl methacrylate, hydrogels, and silicone elastomers. In some embodiments, the polymeric material comprises a drug-eluting polymer matrix. For example, therapeutic agents incorporated in the drug-eluting polymer matrix may include one or more selected from the list of antibiotics, anti-inflammatory drugs, and growth factors. Typical materials to be tested for use as ceramic implant materials may include one or more selected from the list of hydroxyapatite, bioactive glass, alumina ceramics, zirconia ceramics, and calcium phosphate ceramics. Typical materials to be tested for use as composite implant materials may include one or more selected from the list of polymer-ceramic composites, metal-ceramic composites, bioactive glass-polymer composites, and carbon fiber reinforced polymers. Of course also other or further implant materials may be tested using the present methods and systems, in particular new and/or untested materials which could have advantageous properties but may not have been previously used due to lack of biocompatibility ("BC") data.

In another or further preferred embodiment, the test material is provided in the form of a component, section, or complete structure of a medical implant. Examples of medical implants to be tested may include one or more selected from the list of cardiovascular implants, orthopedic implants, dental implants, soft tissue implants, or even drug delivery implants. Also other existing or yet to be developed medical implants may be envisaged. Typical components to be tested for use as cardiovascular implants may include one or more selected from the list of stent segments, heart valve components, vascular graft sections, pacemaker lead coatings, and cardiac patch materials. Typical components to be tested for use as orthopedic implants may include one or more selected from the list of bone fixation devices, joint replacement components, bone cement samples, spinal cage sections, artificial ligament materials, and bone filler materials. Typical components to be tested for use as dental implants may include one or more selected from the list of dental implant bodies, surface coatings, dental posts, crown materials, and dental cement samples. Typical materials to be tested for use as soft tissue implants may include one or more selected from the list of surgical mesh sections, suture materials, wound dressing components, tissue scaffold materials, and skin substitute materials. Typical components to be tested for use as drug delivery implants may include one or more selected from the list of drug-eluting coatings, controlled release matrices, drug-loaded polymer sections, microsphere samples, and hydrogel delivery systems.

In some embodiments, the test material comprises a base structure provided with, e.g. partially or fully covered by, a coating. For example, the coating to be tested may include one or more selected from the list of bioactive coatings, anti-fouling coatings, drug-eluting coatings, wear-resistant coatings, and cell-adhesion promoting surface treatments. Of course also other or further surface modifications or coatings may be tested using the present methods and systems, in particular new and/or untested surface treatments which could have advantageous properties but may not have been previously used due to lack of biocompatibility ("BC") data. Typical materials to be tested for use as bioactive coatings may include one or more selected from the list of hydroxyapatite coatings, bioactive glass coatings, growth factor-containing coatings, calcium phosphate coatings, and cell-adhesion peptide coatings. Typical materials to be tested for use as anti-fouling coatings may include one or more selected from the list of hydrophilic polymer coatings, polyethylene glycol-based coatings, zwitterionic coatings, albumin-repellent coatings, and anti-bacterial surface treatments. Typical materials to be tested for use as drug-eluting coatings may include one or more selected from the list of polymer-drug matrices, biodegradable drug carriers, antibiotic-containing coatings, anti-inflammatory agent coatings, and growth factor-releasing surface treatments. Typical materials to be tested for use as wear-resistant coatings may include one or more selected from the list of diamond-like carbon coatings, ceramic surface treatments, titanium nitride coatings, zirconium oxide coatings, and hard chrome coatings. Typical materials to be tested for use as cell-adhesion promoting surface treatments may include one or more selected from the list of plasma-treated surfaces, micro-textured surfaces, nano-structured surfaces, peptide-functionalized surfaces, and proteinmodified surface coatings.

In other or further embodiments, the test material comprises a base material covered by a biocompatible coating. Typical base materials to be tested may include one or more selected from the list of structural metals, engineering polymers, high-strength ceramics, and cost-effective composite materials which may not inherently possess optimal biocompatibility ("BC"). Typical biocompatible coatings to be applied on such base materials may include one or more selected from the list of titaniumbased coatings, hydroxyapatite layers, bioactive glass coatings, noble metal coatings, and polymer-based barrier layers. In some embodiments, the coating thickness may range from nanometers to micrometers. In other or further embodiments, the coating may be applied through various processes including physical vapor deposition, chemical vapor deposition, plasma spraying, sol-gel deposition, or electrochemical deposition. As will be appreciated, the present methods and systems may allow testing of both the immediate and long-term effectiveness of such coatings in maintaining biocompatibility ("BC") despite potential underlying material incompatibility.

In other or further embodiments, the test material comprises a base structure to which a surface modification has been applied over at least part of its surface, or over its entire surface. Typically, the surface modification may alter the surface properties of a base material forming the base structure. For example, surface property modifications to be tested may include one or more selected from the list of surface roughness alterations, surface energy modifications, surface charge modifications, and surface chemistry alterations. In some embodiments, the surface modification may provide time-dependent functionality. Typical time-dependent modifications to be tested may include one or more selected from the list of degradable protective layers, sequential drug-release coatings, transforming surface structures, and adaptive surface treatments. In some embodiments, the solid structure comprises a biocompatible coating covering a bio-incompatible base material. It can also be envisaged that, the surface modification comprises multiple layers. For example, multi-layer coatings to be tested may include one or more selected from the list of barrier-drug layer combinations, adhesion-promoting base layers with functional top coatings, gradated composition coatings, and sequential delivery system coatings.

In preferred embodiments, the test material "M" is prepared under controlled conditions. The material preparation may include cleaning, sterilization, or other treatments required for biocompatibility testing. In some embodiments, the material surface condition is carefully controlled and documented. Most preferably, the test material "M" is characterized before and after testing. The characterization may include surface analysis, composition measurements, or structural evaluation. In some embodiments, the material changes during testing are documented and correlated with biological responses. The test material "M" may also be provided in formats enabling parallel testing. In some embodiments, multiple material variations may be tested simultaneously using separated flow paths. The material samples may be prepared as arrays or sets with systematic variations.

In preferred embodiments, the biological sample "S" comprises living cells "Sc" selected to represent relevant physiological contexts. The biological cells "Sc" may be chosen based on their role in the intended application of the test material "M". In one embodiment, the biological cells "Sc" comprise vascular endothelial cells for testing cardiovascular materials. The endothelial cells may be primary cells isolated from relevant blood vessels or established cell lines. In other or further embodiments, the cells may include smooth muscle cells, fibroblasts, or other vascular cell types. Most preferably, the cells represent the primary cell type that would contact the material in vivo.

The biological sample "S" may comprise different cell preparations. In some embodiments, the cells are cultured as adherent monolayers on the transparent surface 20t. In other or further embodiments, the biological sample "S" may comprise three-dimensional cell cultures, tissue explants, or co-cultures of multiple cell types. Most preferably, the cell preparation method maintains physiologically relevant cell organization and function.

In preferred embodiments, the biological cells "Sc" contain nanocrystals "NC" with color centers "CC" for sensing cellular responses. The nanocrystals may be introduced into the cells through various methods. In some embodiments, the nanocrystals are internalized by the cells through endocytosis. In other or further embodiments, the nanocrystals may be delivered using cell-penetrating peptides, transfection agents, or other delivery methods. Most preferably, the delivery method ensures uniform distribution of nanocrystals while maintaining cell viability.

The nanocrystals "NC" may be specifically targeted within the cells. In some embodiments, the nanocrystals are functionalized with targeting molecules to direct them to specific cellular compartments such as mitochondria, lysosomes, or other organelles. In other or further embodiments, the nanocrystals may be designed to respond to specific cellular processes or molecules. Most preferably, the targeting strategy enables measurement of relevant cellular responses to the test material.

In preferred embodiments, the biological sample "S" is maintained under controlled environmental conditions. The sample environment may include appropriate temperature, pH, gas levels, and nutrients for maintaining cell viability. In some embodiments, the environment may be adjusted to simulate specific physiological conditions. The testing apparatus 100 may be particularly valuable for evaluating cellular responses under realistic conditions.

The biological sample "S" may be monitored throughout the testing period. In some embodiments, cell viability, morphology, and function are assessed using standard methods in addition to quantum sensing measurements. In other or further embodiments, the sample may be analyzed for specific molecular markers or responses. Most preferably, multiple assessment methods provide complementary information about cellular responses.

In preferred embodiments, the biological sample "S" preparation is standardized for reproducible testing. The cell preparation may include defined seeding densities, growth periods, and quality control criteria. In some embodiments, reference standards or control samples may be included. The testing apparatus 100 may enable consistent evaluation of material effects across multiple experiments.

Most preferably, the biological sample "S" enables long-term observation of cellular responses. The sample preparation may maintain cell viability and function throughout extended testing periods. In some embodiments, the sample may be monitored for dynamic changes in cellular responses over time. The testing apparatus 100 may be particularly advantageous for evaluating both immediate and delayed effects of test materials.

The biological sample "S" may also be configured for parallel testing of multiple conditions. In some embodiments, multiple samples may be prepared with systematic variations in cell type, density, or other parameters. The sample preparation may enable simultaneous comparison of different cellular responses while maintaining consistent testing conditions. This configuration may facilitate comprehensive evaluation of material biocompatibility "BC".

In preferred embodiments, the nanocrystals "NC" are optimized for cellular quantum sensing applications. The nanocrystals may be designed to provide stable, sensitive measurements while maintaining compatibility with cellular systems. In one embodiment, the nanocrystals "NC" have dimensions between 10 and 300 nanometers, more preferably between 50 and 200 nanometers, more preferably between 70 and 120 nanometers. This size range may be particularly advantageous as the nanocrystals are large enough to host sufficient color centers "CC" while remaining small enough for cellular uptake and distribution. For example, in preferred embodiments each nanocrystal contain at least 100 color centers, preferably at least 200 color centers, most preferably at least 300 color centers providing enhanced sensitivity for detecting cellular responses. For example, each nanocrystal "NC" may contain up to 1000 color centers or more.

The nanocrystals "NC" may be processed to optimize their properties. In some embodiments, the nanocrystals undergo purification and size selection to ensure uniform properties. In other or further embodiments, the nanocrystal surface may be treated to remove contaminants or defects that could interfere with sensing. Most preferably, the processing methods maintain the quantum properties of the color centers while improving biocompatibility or improve quantum properties while maintaining biocompatibility.

In preferred embodiments, the nanocrystals "NC" may be surface functionalized. The surface modification may include coatings or molecules that promote cellular uptake and targeting. In some embodiments, the functionalization may include cell-penetrating peptides, antibodies, or other targeting ligands. Most preferably, the surface chemistry enables specific localization while maintaining quantum sensing capabilities.

The nanocrystals "NC" may be targeted to specific cellular locations. In some embodiments, the surface functionalization directs the nanocrystals to particular organelles or cellular compartments. In other or further embodiments, the targeting may enable sensing of specific cellular processes or responses. Most preferably, the localization strategy provides relevant information about cellular interactions with test materials.

In preferred embodiments, the nanocrystal "NC" concentration is optimized for cellular measurements. The concentration may be adjusted to provide sufficient signal while avoiding cell stress or toxicity. In some embodiments, the uptake and distribution of nanocrystals may be quantified and standardized. The testing apparatus 100 may be particularly valuable for maintaining consistent measurement conditions.

The nanocrystals "NC" may be validated for cellular compatibility. In some embodiments, the effects of nanocrystals on cell viability, function, and behavior are carefully assessed. In other or further embodiments, the stability of nanocrystals within the cellular environment may be evaluated. Most preferably, the validation ensures reliable measurements without perturbing normal cellular responses.

In preferred embodiments, the nanocrystals "NC" enable long-term measurements. The nanocrystal properties may remain stable throughout extended testing periods. In some embodiments, the photostability and quantum properties may be monitored over time. The testing apparatus 100 may be particularly advantageous for tracking cellular responses during prolonged material exposure.

Most preferably, the nanocrystals "NC" provide reproducible sensing capabilities. The nanocrystal preparation and cellular delivery may be standardized for consistent performance. In some embodiments, calibration standards or reference measurements may be included. This standardization may enable reliable comparison of material effects across multiple experiments.

The nanocrystals "NC" may also be adapted for multiplexed measurements. In some embodiments, different nanocrystal populations may be functionalized to sense distinct cellular parameters. The measurement strategy may enable simultaneous monitoring of multiple cellular responses while maintaining measurement sensitivity. This capability may facilitate comprehensive evaluation of material biocompatibility "BC".

The color centers "CC" in the nanocrystals "NC" may provide quantum sensing capabilities through their unique electronic and spin properties. The quantum states of these color centers may be manipulated and measured optically, enabling detection of local magnetic fields and other environmental parameters within living cells. In preferred embodiments, the color centers "CC" comprise nitrogen-vacancy (NV) centers in diamond nanocrystals. Also other color centers can be used. In general, the color centers feature electron spin states that can be initialized, manipulated, and read out using optical and magnetic fields. Most preferably, the color centers maintain their quantum properties within the cellular environment while providing sensitive detection of biological responses.

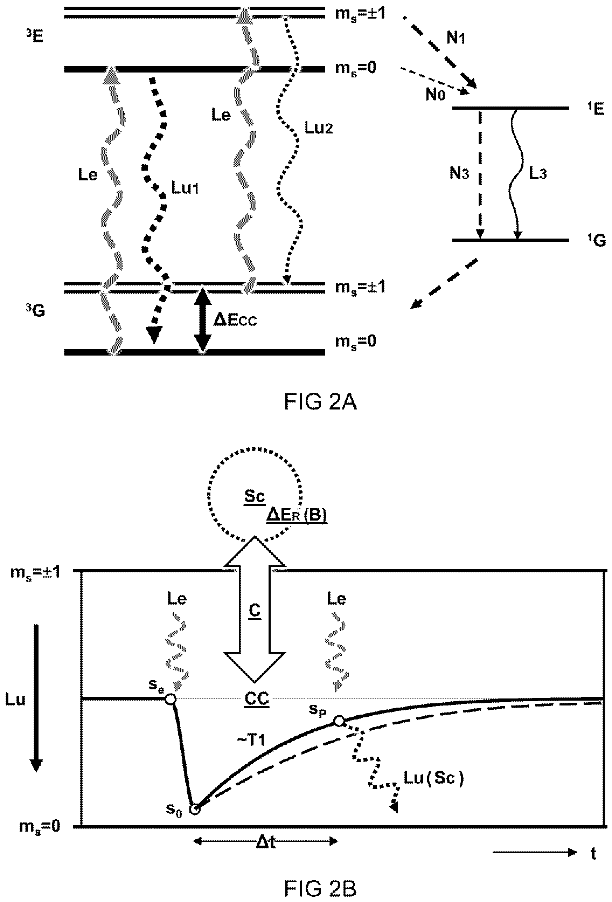

FIG 2A schematically illustrates an energy level diagram for a colour center "CC".

Energy levels indicated with the letter "G" refer to the colour center in the electronic ground state. Energy levels indicated with the letter "E" refer to the colour center in the electronic excited state. The numbers "3" in ³G and ³E and "1" in ¹G and ¹E represent the number of allowable spin states "mₛ", i.e. spin multiplicity. This may range from -S to S for a total of 2S+1 possible states. For example, in a triplet state where S = 1, mₛ can be -1, 0, or 1. The energy difference ΔE_{CC} between the mₛ=0 and mₛ=±1 states typically corresponds to the microwave region. Accordingly, this may couple to magnetic resonances in the region of the cell "Sc" having a matching energy ΔE_{R} depending on the magnetic field "B". The coupling may thus affect the relative population of those levels, thereby affecting the luminescence intensity L. This is one of the mechanisms by which magnetic resonances in the region of the cell "Sc" can be detected.

Transitions between the (electronic) ground triplet state ³G and (electronic) excited triplet state ³E may be effected by absorption of photons, in the present case by excitation with a input light "Li". Decay of the electronic excited state ³E can produce a photon which is measured as luminescence Lu₁ or Lu₂. Alternatively, the excited state may decay also to the excited singlet state ¹E via non-radiative transitions N₀ or N₁, depending on the spin-state mₛ. The excited singlet state ¹E may decay to the ground singlet state ¹G via non-radiative decay path N₃. The singlet decay may also produce luminescence L₃, but at another, relatively high, wavelength (low energy). The ground singlet state ¹G may non-radiatively convert back to the ground triplet state ³G.

Preferably, a likelihood of a radiative versus non-radiative decay depends on the electron-spin mₛ of the colour center. For example, in the case of the Nitrogen-Vacancy colour center, a likelihood of radiative decay Lu₁ for an electron-spin mₛ=0 is higher than radiative decay Lu₂ for an electron-spin mₛ=+1. Conversely, the likelihood of non-radiative decay N₀ for electron-spin ms=0 is lower than non-radiative decay N₁ an electron-spin mₛ=±1. The total amount of luminescence "Lu"=Lu₁+Lu₂ depends on the likelihood of the radiative decay, which is higher when the colour center is in the ms=0 state. Also, due to the different decay paths, the colour center is more likely to be in the mₛ=0 state after excitation, which is one way to initialize the colour center to a known state.

FIG 2B illustrates an example of an average electron-spin state occupancy during different steps of some of the methods as described herein. In a quantum system the spin state is measured in one of discrete eigenstates. The present diagram may thus illustrate the chance of measuring one or the other state, e.g. determined by repeated measurements and/or measuring an ensemble of colour centers.

The average occupancy of the electron-spin may start at an equilibrium value mₛ="sₑ", e.g. determined according to a Boltzmann distribution depending on the energy of the different states. In one embodiment, the initial state mₛ=s₀ is set by the input light "Li" (pump) coinciding colour center. This may cause a transition of the colour center to an electronic excited state ³E, which -after decay- predominantly leaves the colour center in one of specific spin states, e.g. mₛ=0. This initialized spin state mₛ=s₀ may evolve according to a progression which may be influenced by the presence of a nearby resonance of the region of the cell "Sc" during a time period "Δt". After this time, the spin-state may have progressed to a state mₛ=sₚ. The progressed spin state "sₚ" may be read out using a second light beam "Li" (probe) which is directed to coincide with the colour center. This may produce luminescence light. The amount of luminescence "Lu" may be a function of the electron-spin (mₛ) which may be dependent on the progression of the electron-spin mₛ="sₚ", which may be dependent on the resonance energy ΔE_{R} of the region of the cell "Sc", which may be dependent on the magnetic field "B" in the region of the cell "Sc", which may be dependent on the environment in or around the cell "Sc".

In one embodiment, a relaxation time T₁ of the color centers "CC" is measured. For example, the relaxation time T₁ of a respective color center "CC" is dependent on a coupling between the color center and a respective region of the cell "Sc". In some embodiments, the relaxation time T₁ decreases for increased coupling "C" when the energy ΔE_{R} of the region of the cell "Sc" matches an energy ΔE_{CC} of the color center "CC"

In some embodiments, the color centers "CC" within the nanocrystals "NC" are given a predefined time Δt to couple or interact with the local cellular environment of their respective regions of the cell "Sc" under the influence of the specific magnetic field "B". For example, the coupling between the color centers and their local cellular environment may depend on metabolic state, presence of free radicals, and other factors affecting the magnetic environment within the cell "Sc". According to the invention, this allows real-time monitoring of cellular responses to external materials. For example, the color centers "CC" are pumped by input light "Li" from an equilibrium state sₑ to an initial state s₀, wherein the sensors decay back to equilibrium state sₑ according to a relaxation time T₁.

In preferred embodiments, the optical measurements as described herein may follow a predetermined protocol optimized for detecting cellular responses. The measurements comprise applying a sequence of optical pulses to the color centers "CC", with each sequence including initialization and probe pulses separated by controlled time intervals "Δt". The first pulse in each sequence initializes the color centers "CC" into a defined electron spin state (ms=0), while the second pulse enables readout of the evolved state through induced luminescence "Lu". The time interval "Δt" between initialization and probe pulses may be systematically varied during the measurements. For each selected time interval, multiple measurement iterations may be performed to obtain statistically significant data. The luminescence "Lu" induced by the probe pulse may be measured and averaged across these iterations, providing an averaged luminescence value characteristic of that specific time interval. The averaged luminescence values obtained for different time intervals "Δt" may be fitted to an exponential decay curve to determine the relaxation time (T1) of the color centers "CC". This relaxation time may serve as an indicator of the coupling between the color centers and their local cellular environment. For example, changes in T1 may reflect alterations in the cellular magnetic environment caused by metabolic responses to the test material "M".

The testing apparatus 100 may employ different measurement modes depending on specific testing requirements. In one embodiment, continuous wave excitation is applied to the color centers "CC", enabling monitoring of steady-state luminescence intensity. This mode may provide rapid feedback about cellular responses through temporal variations in luminescence intensity. In another or further embodiment, pulsed measurements are performed to obtain detailed spin state information at selected time points. Most preferably, the measurement protocol alternates between continuous and pulsed modes, combining the advantages of rapid monitoring with detailed state characterization. In particular, when operating in continuous wave mode, the excitation wavelength may be carefully selected to minimize cellular autofluorescence while maintaining efficient excitation of the color centers "CC". The steady-state luminescence intensity may provide a baseline indicator of the biological response "Br", with temporal changes in intensity revealing dynamic aspects of cellular responses to the test material "M".

In some embodiments (not shown), an additional magnetic field is produced e.g. by an antenna. For example, the antenna can produce the additional magnetic field at a modulation frequency matching an energy difference between electron-spin states mₛ of the colour center for manipulating a progression of the electron-spin by facilitating a transition between the electron-spin states. For example, the measured luminescence is enhanced or suppressed depending on whether the modulation frequency of the electron beam matches the energy difference between the electron-spin states mₛ. For example the spin can be configured to be sensitive to a particular external resonance. Alternatively, or in addition, the magnetic field modulation can also be used to manipulate the spin of the sample. In other or further embodiments (not shown), the state of the electron-spin mₛ is manipulated after initialization to obtain a quantum superposition of at least two electron-spin states mₛ=0; mₛ=±1. For example, a probability of measuring a specific electron-spin state is dependent on a relative phase of wave functions in the quantum superposition. Accordingly, a progression of the relative phase may be dependent on a relative energy of the electron-spin states and/or the relative energy of the electron-spin states is dependent on the magnetic field "B". In one embodiment, a probability of measuring a specific electron-spin state is dependent on a coherence of wave functions in the quantum superposition. For example, a coherence of the quantum superposition is dependent on the magnetic field "B".

In one embodiment, a first radiofrequency field "RF1" (not shown) is applied to coherently manipulate the spin of the color centers within the cells, e.g. creating a quantum superposition. For example, when using such quantum superposition states, the T2 coherence time of the color centers may provide higher sensitivity than T1 relaxometry for detecting certain cellular responses. In some embodiments, the RF1 field may comprise multiple frequencies applied simultaneously. In another or further embodiment, a second radiofrequency field "RF2" (not shown) is applied to specifically interact with particular molecular species within the cells. For example, RF2 may be tuned to match specific electron spin resonances of cellular components or introduced materials. In some embodiments, RF 1 and RF2 are synchronized to enable double electron-electron resonance (DEER) measurements within the cellular environment. This may allow selective detection of specific molecular interactions when the condition ΔER=frequency of RF2 is met, resulting in enhanced coupling C that affects the measured luminescence signal "Lu".

In preferred embodiments, the testing apparatus 100 enables spin manipulation through precisely controlled radiofrequency fields. A first radiofrequency field "RF1" is applied between initialization and probe pulses to create quantum superposition states of the color centers "CC". The RF1 field frequency is matched to the energy difference "ΔECC" between electron spin states (ms=0, ms==+1), enabling coherent manipulation of the quantum states. A second radiofrequency field "RF2" may be applied simultaneously, tuned to specific electron spin resonances "ΔER" within the biological cells "Sc". This dual-field configuration enables detection of coupling "C" between the color centers "CC" and specific molecular species in their local cellular environment through changes in the measured luminescence "Lu". Most preferably, the RF field parameters are optimized for detecting particular cellular responses of interest.

While preferred embodiments have been shown and described wherein nanocrystals with color centers inside biological cells may provide advantages such as direct intracellular sensing capabilities and high spatial resolution of cellular responses, also other or further embodiments may be envisaged. For example, in other or further embodiments, crystals with color centers may be used that are positioned outside and/or in proximity to the cells. These may be nanocrystals or crystals of larger dimensions (for example up to one micrometer, or even up to one millimeter, or more), and may be positioned between cells, adjacent to cell clusters, or even forming a surface or wall against which the biological cells are disposed. In other or further embodiments, nanocrystals and/or larger crystal with color centers may be present both inside and outside the biological cells, enabling simultaneous monitoring of intracellular and extracellular environments. For example, this may provide complementary information about cellular responses occurring internally and compounds or signals released by the cells into their surrounding environment. Such arrangements may offer other or further sensing characteristics, with the intracellular approach generally providing greater sensitivity to subtle internal cellular changes, while external crystal approaches might better detect certain extracellular events or secreted factors. The measurement sensitivity and spatial resolution may differ between these approaches, with each potentially suited to different aspects of biocompatibility testing. The principles of using color centers for sensing biological responses through their effect on spin states remain applicable across these configurations, though the specific implementation details and optimal application scenarios may vary. These approaches could complement the intracellular nanocrystal method described throughout this disclosure, potentially providing additional information about cell-material interactions at different spatial scales or in different testing contexts. So, it will be understood that aspects of the present disclosure may be generalized to include methods and systems wherein the sample region containing the biological sample comprises biological cells and crystals with color centers, wherein the crystals are positioned in at least one of: positioned inside the biological cells; and/or positioned outside the biological cells (preferably in proximity to the biological cells, e.g. between the cells and/or contacting the cells); and/or forming a surface (e.g. a (transparent) wall of the sample compartment) with color centers against which the biological cells are disposed. It will further be understood that any of the embodiments described herein referring to nanocrystals inside the biological cells may be apply mutatis mutandis to these other configurations of crystals.

For the purpose of clarity and a concise description, features are described herein as part of the same or separate embodiments, however, it will be appreciated that the scope of the invention may include embodiments having combinations of all or some of the features described. The various elements of the embodiments as discussed and shown offer certain advantages, such as real-time and continuous monitoring of cellular responses under physiologically relevant conditions, early detection of subtle metabolic changes, and flexible flow configurations adaptable to different material formats, all applicable to various crystal configurations whether inside cells, outside cells, or some combination thereof. Of course, it is to be appreciated that any one of the above embodiments or processes may be combined with one or more other embodiments or processes to provide even further improvements in finding and matching designs and advantages. It is appreciated that this disclosure offers particular advantages to testing medical implant materials, and in general can be applied for any application of determining biocompatibility of a biological sample with a solid test material using color centers as quantum sensors, regardless of their specific positioning relative to the biological cells.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item("S") or implemented structure or function; any of the disclosed devices or portions thereof may be combined together or separated into further portions unless specifically stated otherwise.

## Claims

1. A method for determining biocompatibility ("BC") of a biological sample ("S") with a solid test material ("M"), the method comprising:
providing a testing apparatus (100) comprising:
a material region (10R) containing the solid test material ("M"); and
a sample region (20R) containing the biological sample ("S") comprising biological cells ("Sc") into which nanocrystals ("NC") with color centers ("CC") have been introduced;
providing a liquid medium ("L") fluidly connecting the material region (10R) with the sample region (20R), wherein the liquid medium ("L") is configured to carry any dissolvable components ("Mc") from the solid test material ("M") and bring the dissolvable components ("Mc"), via the liquid medium ("L"), into contact with the biological cells ("Sc") of the biological sample ("S");
performing optical measurements on the biological sample ("S") to determine a time-dependent spin state of the color centers ("CC") of the respective nanocrystals ("NC") as local indicators of a biological response ("Br") of the biological cells ("Sc") to the dissolvable components ("Mc"); and
determining the biocompatibility ("BC") of the biological sample ("S") with the solid test material ("M") based on the optical measurements.

2. The method according to claim 1, wherein the testing apparatus (100) comprises:
a material compartment (10) configured to hold the solid test material ("M") in the material region (10R) with the liquid medium ("L") contacting an exposed surface the solid test material ("M");
a sample compartment (20) configured to hold the biological sample ("S") in the sample region (20R) with the liquid medium ("L") contacting the biological cells ("Sc"); and
at least one channel (15) fluidly connecting the material compartment (10) and the sample compartment (20).

3. The method according to the preceding claim, wherein the testing apparatus (100) comprises a pump (30) configured to control a flow of the liquid medium ("L") between the material region (10R) and the sample region (20R).

4. The method according to the preceding claim, wherein the pump (30) is configured to generate a pulsating flow.

5. The method according to any of the preceding claims, wherein the testing apparatus (100) comprises recirculated flow path including a channel (15) from the material region (10R) to the sample region (20R), and a return flow channel (25) from the sample region (20R) to the material region (10R).

6. The method according to any of the preceding claims, wherein the testing apparatus (100) comprises
a light source (41) configured to generate excitation light ("Le") illuminating the color centers ("CC") in the biological sample ("S"); and
a light detector (42) configured to measure luminescent light ("Lu") from the color centers ("CC") in the biological sample ("S").
wherein the biological sample ("S") is attached to a sample surface (20t) of the sample region (20R), wherein the sample surface (20t) is transparent to light used for the optical measurements.

7. The method according to any of the preceding claims, wherein the solid test material ("M") is an implant material.

8. The method according to any of the preceding claims, wherein the implant material comprises a stent material.

9. The method according to any of the preceding claims, wherein the material region (10R) comprises a stent structure through which the liquid medium ("L") flows, and the biological cells ("Sc") comprise vascular endothelial cells attached to a wall of the sample region (20R), wherein the liquid medium ("L") flows over an exposed surface formed by the biological cells ("Sc").

10. The method according to any of the preceding claims, wherein the liquid medium comprises one or more components selected from: proteins, blood cells, platelets; growth factors, clotting factors, plasma components, and electrolytes.

11. The method according to any of the preceding claims, wherein performing the optical measurements comprises
optically exciting the color centers ("CC") of one or more nanocrystals ("NC") with excitation light ("Le"); and
measuring luminescent light ("Lu") emitted by the one or more nanocrystals ("NC") in response to the excitation light ("Le");
wherein the biocompatibility ("BC") is determined based on the measured luminescent light ("Lu").

12. The method according to any of the preceding claims, wherein performing the optical measurements comprises:
applying a first pulse of the excitation light ("Le") to optically polarize electron spins of the color centers ("CC") into a defined spin state (ms=0);
waiting for a period of time ("Δt") without applying the excitation light ("Le") for allowing the spin state of the color centers ("CC") to evolve;
applying a second pulse of the excitation light ("Le"); and
measuring luminescent light ("Lu") induced by the second pulse;
wherein the measured luminescent light ("Lu") is indicative of the evolved spin state of the color centers ("CC") being affected by a respective surrounding environment of a respective biological cell ("Sc").

13. The method according to any of the preceding claims, wherein the dissolvable components ("Mc") from the solid test material ("M") affect the biological response ("Br") of the biological cells ("Sc"); wherein the biological response ("Br") of the biological cells ("Sc") affects a magnetic environment within the biological cells ("Sc"); wherein the magnetic environment within the biological cells ("Sc") influences the spin state of the color centers ("CC"); wherein the spin state of the color centers ("CC") is determined by the optical measurements.

14. The method according to any of the preceding claims, wherein the biological response ("Br") of the biological cells ("Sc") to the dissolvable components ("Mc") includes one or more of:
a production or reduction of free radicals within the biological cells ("Sc"), wherein the free radicals affect a local magnetic field sensed by the color centers ("CC");
a change in metabolic activity of the biological cells ("Sc"), wherein the change in metabolic activity affects concentrations of paramagnetic species sensed by the color centers ("CC");
a stress response of the biological cells ("Sc"), wherein the stress response affects local temperature and pH conditions sensed by the color centers ("CC");
an inflammatory response of the biological cells ("Sc"), wherein the inflammatory response affects electron spin noise sensed by the color centers ("CC");
a change in cell membrane permeability, wherein the change in permeability affects ion concentrations sensed by the color centers ("CC");
a change in mitochondrial function, wherein the change in mitochondrial function affects local magnetic noise sensed by the color centers ("CC");
an oxidative stress response, wherein the oxidative stress affects free radical concentrations sensed by the color centers ("CC"); and
an apoptotic response, wherein the apoptotic response affects local magnetic field fluctuations sensed by the color centers ("CC");

15. A testing apparatus (100) for determining biocompatibility ("BC") of a biological sample ("S") with a solid test material ("M"), the testing apparatus (100) comprising:
a material compartment (10) forming a material region (10R) configured to hold the solid test material ("M");
a sample compartment (20) forming a sample region (20R) configured to hold the biological sample ("S") comprising biological cells ("Sc") into which nanocrystals ("NC") with color centers ("CC") have been introduced;
a flow system comprising with a pump (30) configured to control flow of a liquid medium ("L") from the material compartment (10) to the sample compartment (20);
an optical measurement system comprising:
a light source (41) configured to generate excitation light ("Le") for illuminating the biological sample ("S") held in the sample region (20R);
a light detector (42) configured to measure luminescent light ("Lu") emitted from the biological sample ("S") in response to the excitation light ("Le"); and
a control unit (50) configured to:
control the optical measurement system to perform time-dependent measurements of a spin state of the color centers ("CC"); and
determine the biocompatibility ("BC") based on the time-dependent measurements.
